# EUROPEAN PATENT APPLICATION

(11) **EP 1 548 806 A1**
(43) Date of publication of application: **29.06.2005**
(21) Application number: 03794131.7
(22) Date of filing: 29.08.2003
(51) Int. Cl.: H01L 21/027, G03F 1/16, G03F 7/20, G03F 9/00

(54) **ALIGNMENT METHOD, ALIGNMENT SUBSTRATE, PRODUCTION METHOD FOR ALIGNMENT SUBSTRATE, EXPOSURE METHOD, EXPOSURE SYSTEM AND MASK PRODUCING METHOD**

(30) Priority: 02.09.2002 JP 2002256369
(71) Applicant: Sony Corporation, Tokyo 141-0001 (JP)
(72) Inventor: KOIKE, Kaoru, SONY CORPORATION, Tokyo 141-0001 (JP)
(74) Representative: Thévenet, Jean-Bruno
(86) International application number: PCT/JP2003/011016
(87) International publication number: WO 2004/023534

(57) **Abstract**

An alignment method capable of performing alignment without providing alignment marks on a mask and preventing a decline of exposure throughput and latent image contrast, an alignment substrate and the production method, an exposure method, an exposure apparatus and a production method of a mask are provided. An alignment method including a step of transmitting a light or a charged particle beam from a first surface side of a thin film to a second surface side, reflecting the light or charged particle beam on a plurality of alignment marks arranged on the second surface side of the thin film but outside the thin film, detecting the reflected light or charged particle beam on the first surface side, and detecting positions of the alignment marks, and a step of obtaining position coordinates on the thin film; an alignment substrate used for the alignment method and a production method thereof, an exposure method for performing the alignment, an exposure apparatus and a production method of a mask.

## Description

### TECHNICAL FIELD

The present invention relates to an alignment method, an alignment substrate, a production method of an alignment substrate, an exposure method, an exposure apparatus and a production method of a mask.

### BACKGOUND ART

Conventionally, in a production process of a semiconductor device, a lithography technique using an ultraviolet ray has been mainly used in a step of transferring a circuit pattern, such as wiring, to a semiconductor substrate. In recent years, semiconductor devices have been developed to be highly integrated and, along therewith, there are demands for furthermore miniaturizing wiring and other circuit patterns than before. However, as the miniaturization proceeds, pursuit of a shorter wavelength of a lithography light source has been on the way to deadlock and a new exposure technique has been expected.

A lithography technique using a charged particle beam typified by an electron beam and X-ray has gathered attentions. In the charged particle beam or X-ray lithography, a membrane mask or a stencil mask, wherein a wafer is the base, is used.

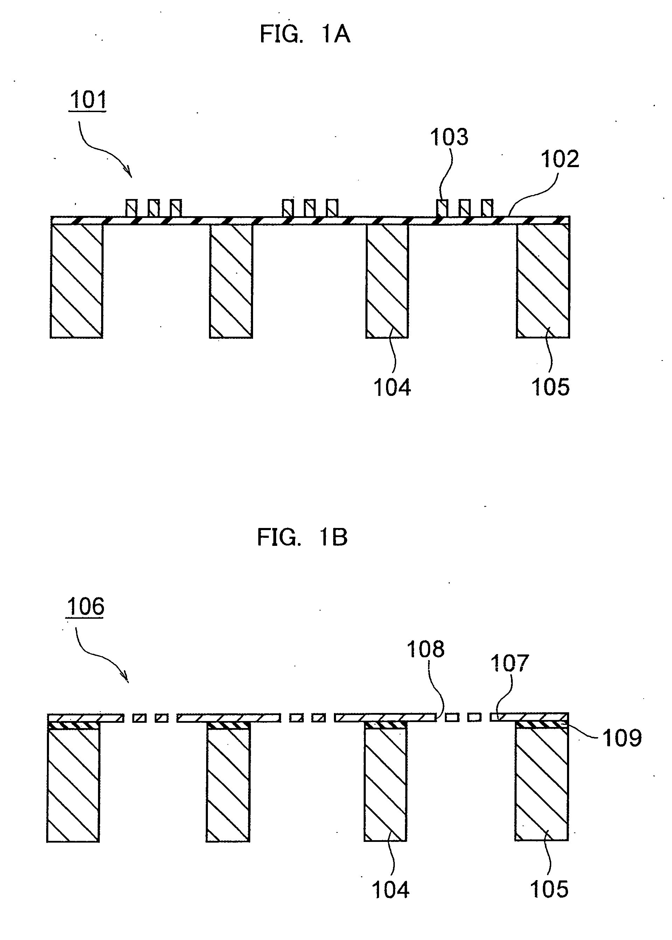

FIG. 1A is a sectional view of a membrane mask. The membrane mask 101 is obtained by arranging on an extremely thin membrane 102 for transmitting a charged particle beam or an X-ray an absorbing material 103 for reflecting/scattering/absorbing the charged particle beam or X-ray corresponding to a circuit pattern shape to be exposed. On a surface on the side not formed with the absorbing material 103 of the membrane 102 are formed beams 104 and supporting frame portions 105 by performing etching, for example, on a silicon wafer.

FIG. 1B is a sectional view of a stencil mask. The stencil mask 106 is obtained by providing opening portions 108 corresponding to a circuit pattern shape to be exposed on a thin membrane 107 for reflecting/scattering/absorbing the charged particle beam or X-ray. On a surface on one side of the membrane 107 are formed beams 104 and supporting frame portions 105 by performing etching, for example, on a silicon wafer. In the etching for forming the beams 104 and the supporting frame portions 105, the membrane 107 is protected by an etching stopper layer 109 from being etched. As explained above, either of the masks uses a thin film (membrane).

On the other hand, high positional accuracy is also required to a mask, as the circuit pattern becomes miniaturized. Generally, electron beam lithography is used for mask exposure for forming a pattern on a mask, and accurate alignment of an electron beam for performing exposure is required for attaining high positional accuracy.

However, even if a beam is sufficiently aligned at the time of starting mask exposure, since an electron beam exhibits a phenomenon called drift when drawing a pattern, inaccuracy increases in a certain direction over time. Accordingly, to maintain sufficient accuracy, drawing of a pattern is suspended cyclically in accordance with a drift amount of the electron beam, and when an alignment error exceeds tolerance, the beam position is adjusted again.

The beam position adjustment is performed by irradiating an electron beam to, for example, a mark made by tungsten on a stage and detecting reflected electrons, and based on the detection result of a stage position at that time. In the electron beam position adjustment, the stage is moved from a stage position for performing exposure to a stage position for detecting, so that an error may be actually introduced due to a slip of the stage or a stress relating to other movement. Furthermore, due to the moving of the stage, an excessive time is required other than performing exposure, which results in a decline of throughput.

To perform the alignment of the electron beam with high accuracy, there has been proposed a system called Spatial-phase-locked electron beam lithography (SPLEBL) by the MIT in the United States (refer to the specification of the U.S. Patent No. 5892230 and an article "Spatial-phase-locked Electron-beam Lithography: Initial Test Results" pp 2342 to 2345, J. Vac. Sci. Technol. B. Vol. 11, No. 6 Nov. Dec. 1993).

Also, another alignment technique has been proposed by the Naval Research Laboratories (NRL) (refer to the specification of the U.S. Patent No. 5703373 and article "Improving pattern placement using through-the-membrane signal monitoring", J. Vac. Sci. Technol. B 16(6), Nov/Dec 1998, pp 3567 to 3571). In this technique, an alignment grid is placed immediately under an X-ray membrane, and the alignment grid forms Schottky diode junction. Since the Schottky diode junction functions as a detector of an incident electrons, alignment information can be obtained by an electron beam for performing exposure in the same way as in the method by the MIT.

Also, a method of providing two kinds of alignment marks on a mask (reticle) and correcting distortion of the reticle at the time of mask exposure has been disclosed (refer to the Japanese Unexamined Patent Publication No. 2000-124114). In this method, the entire pattern is divided to small regions (sub-fields), a charged particle beam is irradiated to every sub-field, and sub-field images are combined on a substrate to transfer and exposure the entire pattern; wherein first alignment marks are arranged between the sub-fields and the second alignment marks are arranged on the sub-fields. By using two kinds of alignment marks, a distortion arisen at the time of loading the reticle to an exposure apparatus and a distortion due to errors, etc. at the time of producing the reticle are detected and corrected.

Furthermore, there has been disclosed a method of fixing a position detection member produced separately from the mask to an X-ray mask instead of forming position reference marks on the mask by etching and using the same for position detection at the time of drawing a mask pattern (refer to the Japanese Unexamined Patent Publication No. 2000-31008).

Among the above conventional arts, in the SPLEBL, special alignment marks are provided on a substrate, allover the substrate surface is scanned by an electron beam for exposure, and a returned signal is detected to obtain alignment information at the same time as the exposure. Therefore, high positional accuracy can be obtained, however, as a first problem, the special alignment marks have to be provided on the substrate in advance.

Also, the alignment marks are arranged on a pattern and non-pattern at several µm pitches. Since drawing is performed while reading a signal of alignment information at all alignment marks, as a second problem, exposure becomes slow.

As a third problem, since exposure on the overall resist surface on the substrate is performed by an electron beam for reading a signal of alignment information, latent image contrast declines. Due to these problems, the SPLEBL is used only on an experimental level.

In the NRL method, being different from the SPLEBL, alignment marks are made not on the substrate but below the membrane, so that the first problem of the SPLEBL is solved. However, the second and third problems still remain.

Also, in the case of the method described in the Japanese Unexamined Patent Publication No. 2000-124114, the first and second alignment marks are formed on the reticle, so that there is the same problem as the first problem of the SPLEBL.

The method described in the Japanese Unexamined Patent Publication No. 2000-31008 is effective for preventing contamination on the mask due to dusts generated in an etching step for forming the position reference marks and the subsequent washing step, but the position reference marks cannot be provided on the membrane, so that a plurality of position reference marks cannot be arranged evenly on the mask.

### DISCLOSURE OF THE INVENTION

The present invention was made in consideration of the above problems, therefore, an object of the present invention is to provide an alignment method capable of aligning with high accuracy without providing alignment marks on a mask and preventing a decline of throughput of exposure and a decline of latent image contrast due to alignment, an alignment substrate, a production method of an alignment substrate, an exposure method, an exposure apparatus and a production method of a mask.

To attain the above object, an alignment method of the present invention is characterized by comprising: a step of transmitting an exposure beam from a first surface side of a thin film to a second surface side and reflecting said exposure beam on a plurality of alignment marks arranged on said second surface side of said thin film and outside said thin film; a step of detecting said exposure beam reflected on said alignment marks at said first surface side and detecting positions of said alignment marks; and a step of obtaining position coordinates on said thin film using said detected position of said alignment marks.

Also, to attain the above object, an alignment substrate of the present invention is characterized by being arranged so that a surface thereof faces a second surface of a thin film at said second surface side of said thin film, into a first surface thereof an exposure beam entering, and comprising a plurality of alignment marks formed on said surface and reflecting said exposure beam transmitting and entering through said thin film at higher reflectance than said surface at periphery thereof.

To attain the above object, a production method of an alignment substrate of the present invention is characterized by comprising: a step of forming an etching stopper layer on a first substrate; a step of forming second substrate on said etching stopper layer; a step of a plurality of alignment marks on a part of said second substrate; a step of performing an etching to a surface layer portion of said second substrate using said alignment marks as a mask, and forming a step between a surface of said second substrate directly below said alignment marks and a surface of said second substrate at periphery of said alignment marks; a step of forming a resist on said alignment marks and on a part of said second substrate at periphery of said alignment marks; a step of performing an etching to said second substrate using said resist as a mask until said etching stopper layer is exposed; and a step of removing said resist.

To attain the above object, an exposure method of the present invention is characterized by comprising: a step of measuring a position coordinates of a alignment marks in a alignment substrate having a plurality of said alignment marks thereon; a step of arranging said alignment substrate so that a surface thereof faces a second surface of a thin film at said second surface side of said thin film, on a first surface thereof a resist being made, a step of transmitting an exposure beam from said first surface side of said thin film to said second surface side and reflecting said exposure beam on said alignment marks; a step of detecting said exposure beam reflected on said alignment marks at said first surface side and detecting positions of said alignment marks; a step of determining positions for drawing a mask pattern on said resist using said detected positions of said alignment marks; and a step of drawing said mask pattern on said resist by an exposure of a charged particle beam, an extremely-short ultraviolet ray, an X-ray, an ultraviolet ray, and/or a radiation.

To attain the above object, an exposure apparatus of the present invention is characterized by comprising: a thin film holding means for holding a thin film applied with a resist on a first surface thereof; an alignment substrate holding means for holding an alignment substrate having a plurality of alignment marks on a surface thereof at a second surface side of said thin film so that said second surface of said thin film faces said surface; an alignment detecting system irradiating an exposure beam at said first surface, reflecting said exposure beam on said alignment marks via said resist and said thin film, detecting said exposure beam reflected on said alignment marks at said first surface side, and measuring position coordinates of said alignment marks; and a charged particle beam source, an extremely-short ultraviolet ray source, an X-ray source, an ultraviolet ray source, and/or a radiation source for drawing a mask pattern on said resist.

To attain the above object, a production method of a mask of the present invention is characterized by comprising: a step of applying a resist on a first surface of a thin film; a step of arranging an alignment substrate having a plurality of alignment marks on a surface thereof at a second surface side of said thin film so that said second surface of said thin film faces said surface; a step of transmitting an exposure beam from said first surface side of said thin film to said second surface side and reflecting said exposure beam on said alignment marks; a step of detecting said exposure beam reflected on said alignment marks at said first surface side and detecting positions of said alignment marks; a step of determining positions for drawing a mask pattern on said resist using said detected positions of said alignment marks; a step of drawing said mask pattern on said resist by an exposure of a charged particle beam, an extremely-short ultraviolet ray, an X-ray, an ultraviolet ray, and/or a radiation; a step of developing said resist; a step of performing an etching to said thin film using said resist as a mask and forming openings along said mask pattern; and a step of removing said resist.

Due to the above, alignment of a thin film can be performed with high accuracy without providing alignment marks on the thin film. An alignment substrate may be used for alignment of other thin film, on which a different mask pattern is drawn. Also, it becomes also possible to perform alignment by using a charged particle beam, an extremely-short ultraviolet ray, an X-ray and/or a radiation to be used for performing exposure of a mask pattern.

### BRIEF DESCRIPTION OF DRAWINGS

FIG. 1A is a sectional view of a membrane mask, and FIG. 1B is a sectional view of a stencil mask.
FIG. 2A is a sectional view of a mask blanks to be aligned by the alignment method of the present invention, FIG. 2B is a sectional view of an alignment substrate of the present invention, and FIG. 2C is a sectional view showing a state where the mask blanks in FIG. 2A and the alignment substrate in FIG. 2B are set.
FIG. 3 is an example of a view from above of the mask blanks shown in FIG. 2A.
FIG. 4 is another example of a view from above of the mask blanks shown in FIG. 2A.
FIG. 5A to FIG. 5C are sectional views showing production steps of a production method of an alignment substrate of the present invention.
FIG. 6A to FIG. 6C are sectional views showing production steps of a production method of an alignment substrate of the present invention, continued from FIG. 5C.
FIG. 7A to FIG. 7C are sectional views showing production steps of a production method of an alignment substrate of the present invention, continued from FIG. 6C.
FIG. 8 is a sectional view showing an alignment method of the present invention.
FIG. 9A and FIG. 9B are examples of a sectional views of a mask blanks to be aligned by the alignment method of the present invention.
FIG. 10A is another example of a sectional view of a mask blanks to be aligned by the alignment method of the present invention, and FIG. 10B is a sectional view showing a state where the mask blanks in FIG. 10A and the alignment substrate of the present invention are set.
FIG. 11 is a sectional view showing another example of the alignment method of the present invention.

### BEST MODE FOR CARRYING OUT THE INVENTION

Below, preferred embodiments of an alignment method, an alignment substrate, a production method of an alignment substrate, an exposure method, an exposure apparatus and a production method of a mask of the present invention will be explained with reference to the drawings. In the present embodiments, lithography for forming a mask pattern on a stencil mask will be explained.

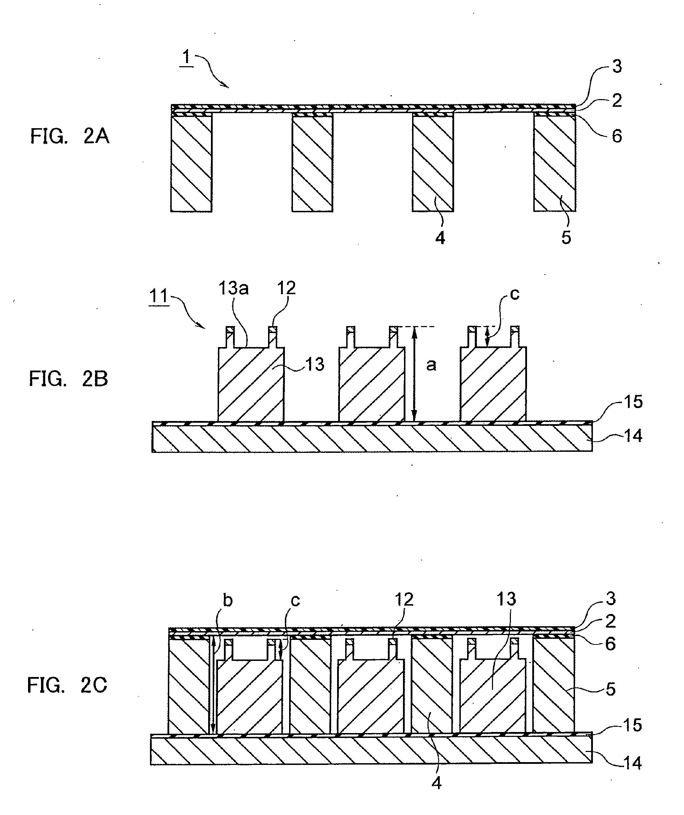

FIG. 2A is a sectional view showing a mask blanks 1 before exposing a mask pattern, and FIG. 2B is a sectional view of an alignment substrate 11 of the present embodiment. FIG. 2C is a sectional view showing a state where the mask blanks 1 in FIG. 2A and the alignment substrate 11 in FIG. 2B are set.

As shown in FIG. 2A, the membrane 2 is applied with a photosensitive resist 3 to an electron beam. While a material of the membrane 2 is not limited, it is single crystal silicon membrane in the present embodiment. A surface on a side not applied with the resist 3 of the membrane 2 is formed beams 4 and supporting frame portions 5 by performing etching on a silicon wafer.

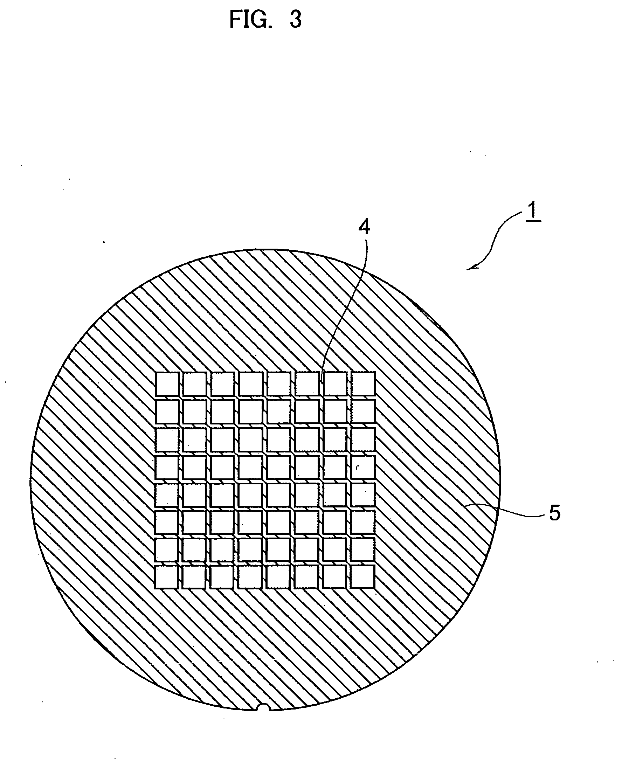

FIG. 3 is an example of a plan view of the mask blanks 1 in FIG. 2A, and the beams 4 are arranged, for example, in a lattice shape as shown in FIG. 3. By forming the beams 4, flexture of the membrane 2 is prevented. Opening portions are formed to be a desired circuit pattern shape on portions not formed with the beams 4 and the supporting frames 5. Formation of the opening portions is performed by using as a mask a resist pattern obtained by performing exposure and development on the resist 3 in FIG. 2A.

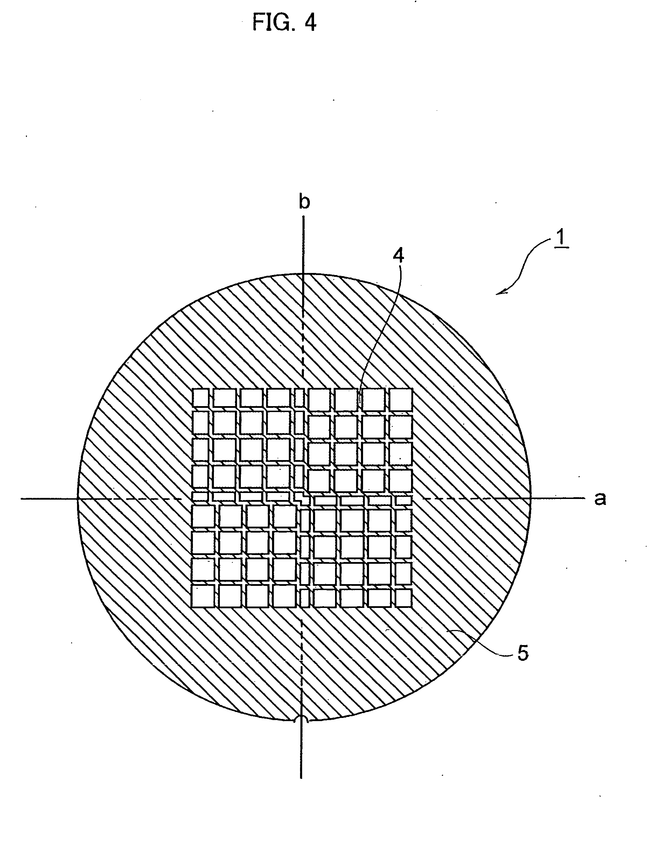

FIG. 4 is another example of a plan view of the mask blanks 1 in FIG. 2A. As shown in FIG. 3, a circuit pattern (opening portions) cannot be arranged on the beam 4 portions on a stencil mask formed with the beams 4. Accordingly, a circuit pattern superimposing with the beam 4 portions has to be arranged on a different stencil mask (complementary mask) wherein position of the beams 4 is different.

On the other hand, in the mask blanks 1 shown in FIG. 4, a region inside the supporting frame 5 is divided to four regions by mutually perpendicular two straight lines "a" and "b", and beams 4 are formed to be shifted from one another on the four regions. A circuit pattern to be formed on the four regions is transferred by exposure by being superimposed on the same position on the wafer.

When the beams 4 are arranged as shown in FIG. 4, a circuit pattern on portions formed with the beams 4 on a certain region can be arranged on other region on the mask, so that it is not necessary to produce and use a plurality of complementary masks. The mask blanks 1 shown in FIG. 3 and FIG. 4 differ only on the arrangements of beams 4, and the sectional configuration and the production method are the same.

In FIG. 3 and FIG. 4, a size of a portion surrounded by the beams 4 may be set in a range capable of preventing flexture of the membrane 2 and may be suitably changed in accordance with a material and thickness of the membrane 2. As an example, when the beams 4 are arranged in a lattice shape on one surface of the silicon membrane 2, a length of a side of a square surrounded by the beams 4 can be made to be 1 mm or so and a width of the beams 4 can be made to be 100 to 200 µm or so.

In the sectional configuration of the mask blanks 1 shown in FIG. 2A, an etching stopper layer 6, for example, made by a silicon oxide film is formed between the layers of the membrane 2 and the beams 4 or membrane 2 and the supporting frame portions 5. The etching stopper layer 6 protects the membrane 2 from being etched in a step of performing etching on the silicon wafer to form the beams 4 and the supporting frame 5.

The mask blanks configured as above can be produced, for example, by using a SOI (silicon on insulator or semiconductor on insulator) substrate. In this case, the beams 4 and the supporting frame portions 5 are formed of the SOI silicon wafer, a buried oxidized film of the SOI substrate is used as an etching stopper layer 6, and the silicon layer is used as the membrane 2.

As shown in FIG. 2B, the alignment substrate 11 has alignment marks 12 on the outermost surface. Alignment mark supporting portions 13 are formed on the substrate 14 via an etching stopper layer 15. The alignment mark supporting portions 13 as a lower layer of the alignment marks 12 have a shape that around the alignment marks 12 is ditched. The surface of the portion, where the alignment mark supporting portion 13 is formed by ditching, around the alignment mark 12 will be referred to as a step portion 13a.

When performing exposure on the resist 3 on the surface of the mask blanks 1 in FIG. 2A, as shown in FIG. 2C, the beams 4 and the supporting frame portions 5 of the mask blanks 1 are set between the alignment mark supporting portions 13 of the alignment substrate 11, and lower ends of the beams 4 and the supporting frame portions 5 are placed on the etching stopper layer 15.

A height "a" shown in FIG. 2B indicates a height of the alignment mark supporting portion 13 and the alignment mark 12 together. The height "a" is set in accordance with the structure of the mask blanks 1 in FIG. 2A. In the mask blanks 1, when the beams 4 and the supporting frame portions 5 are formed by performing etching on a silicon wafer having a diameter of 8 inches (200 mm), since a thickness of the 8-inch wafer is 725 µm, a distance "b" (refer to FIG. 2C) from the beams 4 or the supporting frame portions 5 to the membrane 2 becomes a sum of 725 µm and a thickness of the etching stopper layer 6. The height "a" is made less than the distance "b" but is preferable to be as close to the distance "b" as possible.

While a thickness of the membrane 2 differs in accordance with a material of the membrane 2 and energy of a charged particle beam to be used for exposure, it is generally extremely thin as 0.1 µm to 2 µm or so, so that when the alignment marks 12 on the alignment substrate 11 contact the membrane 2, the membrane 2 is liable to be damaged. Accordingly, positional adjustment in the height direction of the mask blanks and the alignment substrate is significant.

On the other hand, while the production method will be explained later on, the alignment mark supporting portions 13 on the alignment substrate 11 can be formed also by using a silicon wafer. For example, when forming the alignment mark supporting portions 13 by using an 8-inch wafer, the height "a" becomes a sum of 725 µm and a thickness of the alignment marks 12.

A distance "c" from tips of the alignment mark 12 to the step portions of the alignment mark supporting portions 13 depends on an accelerating voltage of an electron beam exposure apparatus (mask exposure apparatus) to be used for mask exposure. At the time of mask exposure, when electrons transmitted through the membrane 2 reflect on the step portions 13a and enters again to the resist 3 on the membrane 2, resolution of the exposure pattern declines. To prevent this, it is preferable that the distance "c" is about 10 µm or more, for example, when the accelerating voltage is 50 to 100 kV.

Due to the configuration that the alignment mark supporting portions 13 are ditched on portions other than the alignment marks 12, reflection strength against an electron beam can be remarkably lowered on the alignment mark supporting portions 13 comparing with that on alignment marks 12, for example, made by tungsten, etc. Namely, it becomes possible to detect the alignment marks 12 at high contrast, and the S/N ratio of a mark signal is improved.

Also, a material of the alignment mark supporting portions 13 is preferably a substance having a small atomic weight so as to suppress reflection of an excessive electron beam. In the present embodiment, in terms of ease of processing and prevention of contamination of the mask blanks 1, the alignment mark supporting portions 13 are formed by performing etching on a silicon wafer.

Positions and density of forming the alignment marks 12 are not particularly limited, but in the case where the portion surrounded by the beams 4 is about 1 mm-square as an example (refer to FIG. 3 and FIG. 4), it is preferable that at least one, preferably a several alignment marks 12 are arranged on one alignment mark supporting portion 13 to be set on a portion surrounded by the beams 4.

Even in the case of arranging several alignment marks 12 on one alignment mark supporting portion 13, intervals of the alignment marks 12 become several hundreds of pm, that is, the mark intervals are obviously wider comparing with the case of the SPLEBL explained above. Accordingly, even though drawing is performed while reading a signal of position information at the alignment marks, the exposure speed does not notably lowered as in the SPLEBL.

Also, according to the present embodiment, the alignment marks 12 are arranged not on the membrane 2 of the mask blanks 1 but on the alignment substrate 11, so that the alignment marks 12 can be formed either on a pattern or non-pattern under a later explained certain condition. However, the mark density is lower comparing with that in the SPLEBL, so that the alignment marks 12 can be arranged selectively on a non-pattern. Accordingly, it is possible to prevent deterioration of latent image contrast due to reading of position information on allover the resist surface, which is observed in the SPLEBL for arranging marks at high density on a pattern and non-pattern.

A thickness of the alignment marks 12 depends on an alignment light and a charged particle beam (electron beam) for alignment, etc. (hereinafter, these will be collectively called as an exposure beam for alignment), but 0.1 to 5 µm or so is preferable when a high acceleration electron beam used for mask exposure is used for alignment. When the thickness of the alignment marks 12 is too thin, reflection strength of an exposure beam for alignment becomes weak and alignment accuracy declines. When the thickness of the alignment marks is too thick, etching of an alignment mark formation layer 22, which will be explained with reference to FIG. 5A later on, becomes difficult.

Next, a production method of producing an alignment substrate of the present embodiment will be explained. In the production method of an alignment substrate of the present embodiment, processing on the alignment mark supporting portion 13 is performed by dividing to two stages. Due to this, the step portions 13a of the alignment mark supporting portions can be formed to be a desired height.

FIG. 5A is a sectional view showing a substrate for producing an alignment substrate 11 shown in FIG. 2. As shown in FIG. 5A, for example, a silicon oxide film is formed as an etching stopper layer 15 on a first silicon wafer as a substrate 14. A second silicon wafer 21 is formed on the silicon oxide film 15 and, for example, a tungsten layer is formed thereon as an alignment mark formation layer 22.

The substrate (first silicon wafer) 14 is assumed to have a thickness capable of supporting the entire substrate, so that the entire substrate shown in FIG. 5A does not bend. As the substrate 14, a standardized wafer used for producing a semiconductor device, etc. can be used and, specifically, the thickness is 525 µm in the case of a silicon wafer having a diameter of 4 inches, (200 mm) and 725 µm in the case of an 8-inch wafer.

Instead of using a silicon wafer as the substrate 14, a silica substrate, etc. may be used. Also, as a material of the alignment mark formation layer 22, for example, tantalum, platinum, gold, iridium and other metals may be used other than tungsten. Also, as the etching stopper layer 15, a silicon nitride film, etc. may be formed.

The etching stopper layer 15 preferably has a thickness so as not to disappear in a later explained etching step of the second silicon wafer 21, that is, about 1 µm or thicker. A thickness of the second silicon wafer 21 is determined based on a height of beams and supporting film portion of the stencil mask (refer to FIG. 2).

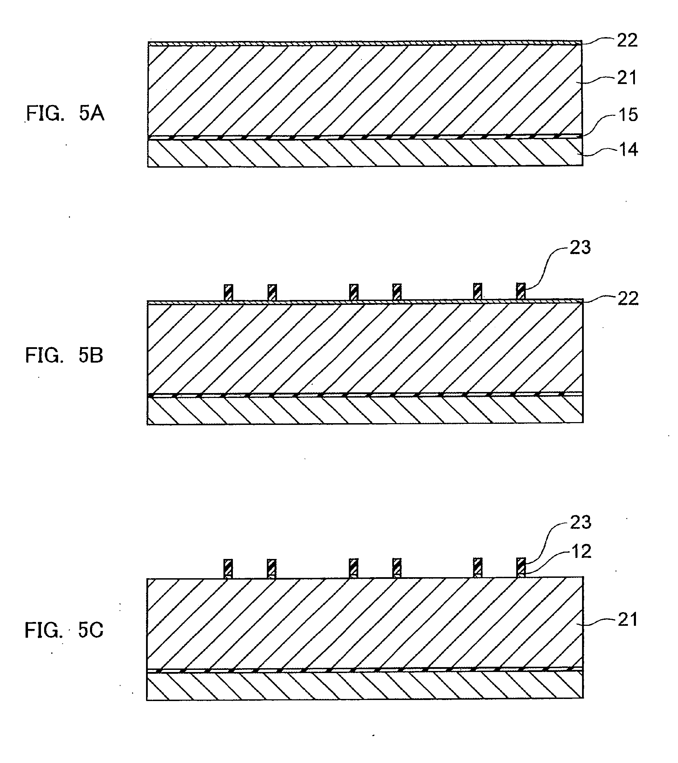

Next, as shown in FIG. 5B, a resist 23 is formed to be a pattern of alignment marks 12 (refer to FIG. 2) on the alignment mark formation layer 22 as shown in FIG. 5B. To form the resist 23 to be a pattern of alignment marks 12, after applying the resist to the whole surface, exposure is performed by an electron beam and ultraviolet ray, etc. for development. Next, as shown in FIG. 5C, etching is performed on the alignment marks formation layer 22 by using the resist 23 as a mask to form alignment marks 12 made by tungsten.

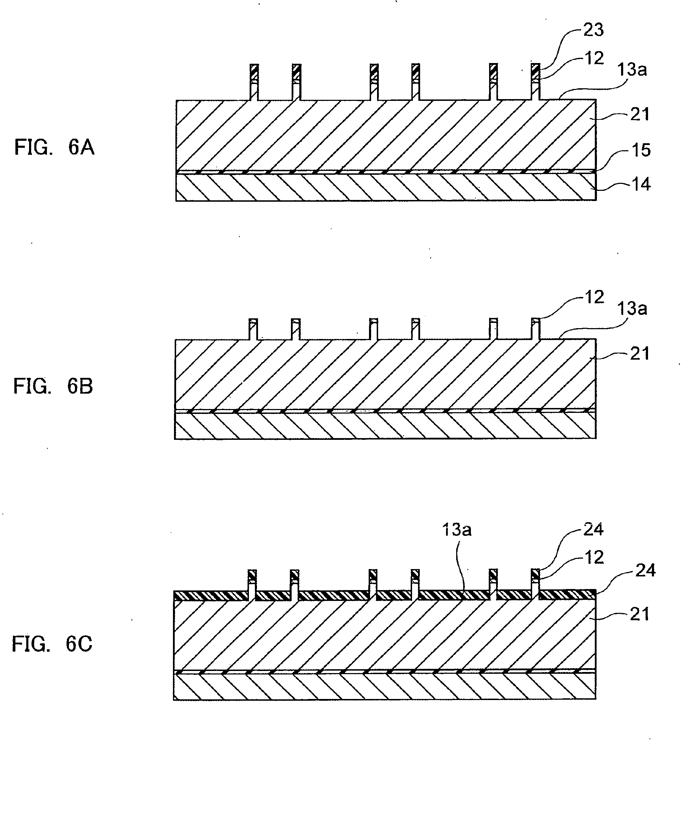

Next, as shown in FIG. 6A, the resist 23 and the alignment mark 12 are used as masks to perform etching to predetermined depth on a surface portion of the second silicon wafer 21. A part of the surface obtained by the etching becomes a step portion 13a of the alignment mark supporting portion (refer to FIG. 2). After that, as shown in FIG. 6B, the resist 23 is removed and washing is performed.

Next, as shown in FIG. 6C, to process the remaining portion of the second silicon wafer 21, a resist 24 is applied to the whole surface. At this time, a positive type resist is preferably used as the resist 24. In the present embodiment, there is a level difference between the alignment mark 12 part and other part (ditched portions 13a of the alignment mark supporting portions), and a part of the resist on the ditched portion 13a as the lower level is removed.

Since an exposed part becomes soluble in a positive type resist, it is sufficient to focus only on the lower level side when using the positive type resist, and it is not necessary to have focus depth by which both of the upper level (resist on the alignment marks 12) and the lower level are suitably exposed. Because the resist 24 is left on all of the upper level, the resist on the upper level does not have to be exposed when using a positive type resist.

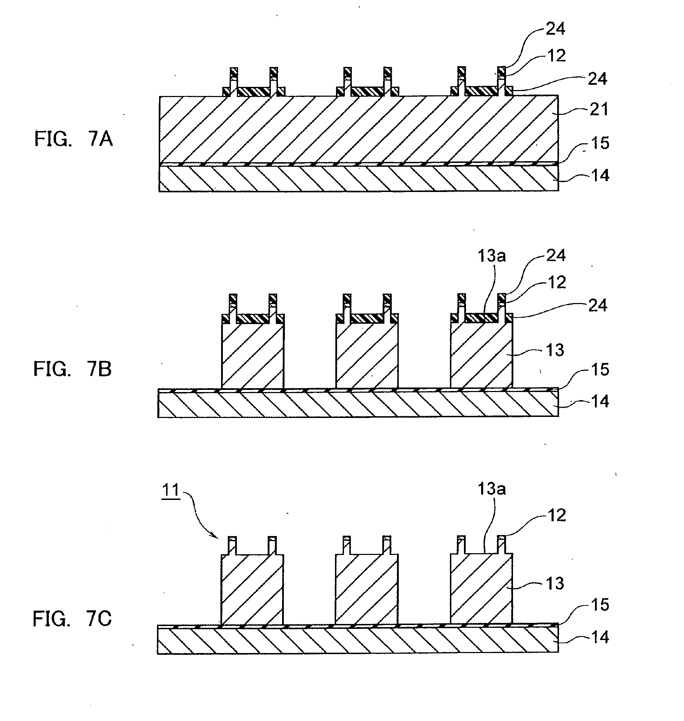

Next, as shown in FIG. 7A, exposure and development are performed on the resist 24, and only the resist 24 on a part for forming the alignment mark supporting portions 13 (refer to FIG. 2) is left.

Next, as shown in FIG. 7B, etching is performed on the second silicon wafer 21 by using the resist 24 as a mask until the etching stopper layer 15 exposes, and the alignment mark supporting portions 13 are formed.

It is also possible to finish the etching at a stage that etching of an amount of a thickness of the second silicon wafer 21 is performed, for example, by controlling an etching amount by the etching time and without using an etching stopper layer. But by using the etching stopper layer 15, the flatness degree on the etching surface can be improved.

Since the beams 4 and the supporting frame portions 5 of the mask blanks 1 (refer to FIG. 2) are placed on the portions where the second silicon wafer 21 is removed, when the surface flatness degree is poor, the mask blanks cannot be stably set and positional accuracy at mask exposure declines. To prevent this, it is preferable to provide the etching stopper layer 15 as a base of the second silicon wafer 21.

On the other hand, in a step of performing etching on the second silicon wafer 21 partway to form the step portions 13a (refer to FIG. 6A), it is sufficient if etching depth that an exposure beam for alignment reflected on the step portions 13a does not enter the resist for mask pattern transfer (resist of mask blanks) is obtained. Accordingly, the surface flatness degree is not required as in performing etching of an amount of a thickness of the second silicon wafer 21, and etching can be performed without providing an etching stopper layer.

After that, as shown in FIG. 7C, by removing the resist 24 and washing, the alignment substrate 11 is completed.

The produced alignment substrate 11 is measured positions of the alignment marks 12 with high accuracy before being used for mask exposure. Position coordinates of the measured alignment marks 12 are input to a mask exposure apparatus. At the time of mask exposure, the input position coordinates and alignment mark detection results of the mask exposure apparatus are matched, and mask exposure is performed so as not to cause distortion on a pattern to be transferred. When mask exposure is performed in a state where alignment is performed under a condition that position coordinates input to the mask exposure in advance matches with alignment mark detection results of the mask exposure, a pattern without distortion can be transferred.

Note that in the case where positional accuracy is insufficient when a position of a pattern exposed on the mask blanks 1 (refer to FIG. 2) is measured, or in the case where the pattern position is deviated when exposure is performed on the wafer by using a stencil mask obtained by performing etching on the membrane after mask exposure, the above alignment may be corrected.

Next, a method of performing mask exposure by using the alignment substrate of the present embodiment will be explained in detail. In the mask blanks 1 shown in FIG. 2, the mask blanks 1 does not have to be specially devised if the resist 3 on the mask blank is not exposed by the electron beam for alignment. Also, in this case, even if a pattern is arranged on the membrane on the alignment marks 12, the resist 3 is not exposed in alignment, so that the alignment marks 12 can be arranged regardless of the pattern position.

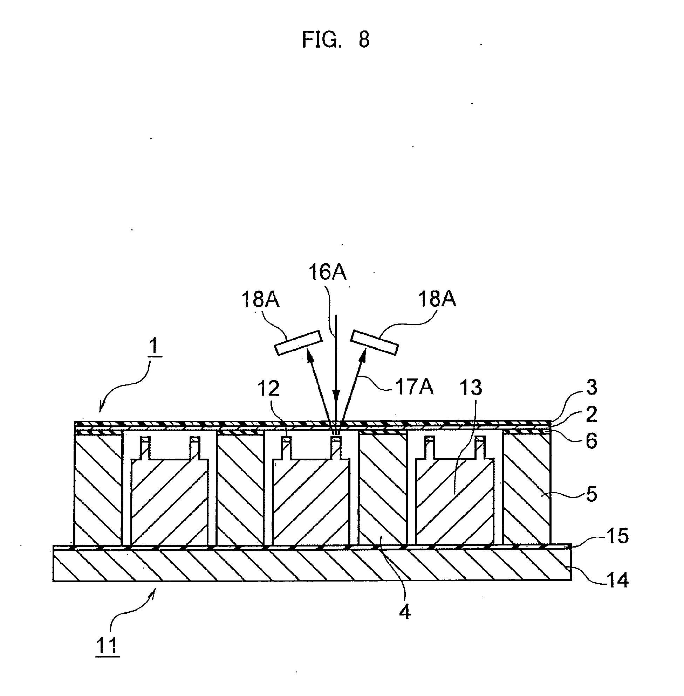

As a specific example of the case where the resist 3 is not exposed by the exposure beam for alignment, the case of performing mask exposure by an electron beam having an acceleration voltage of 50 kV and using a laser beam having a wavelength of 780 nm as the exposure beam for alignment may be mentioned. FIG. 8 shows a sectional view for performing alignment in such a case. As shown in FIG. 8, the exposure beam for alignment 16A transmits the membrane 2 and the resist 3 thereon and enters the alignment marks 12.

Alignment accuracy required at this time depends on a margin of matching the membrane 2 with a mask pattern drawn on the resist 3. When the margin for matching the membrane 2 and the mask pattern is small, mask side alignment marks, which can be detected by the exposure beam for alignment, are provided on the membrane 2 of the mask blanks 1 by following the conventionally known method.

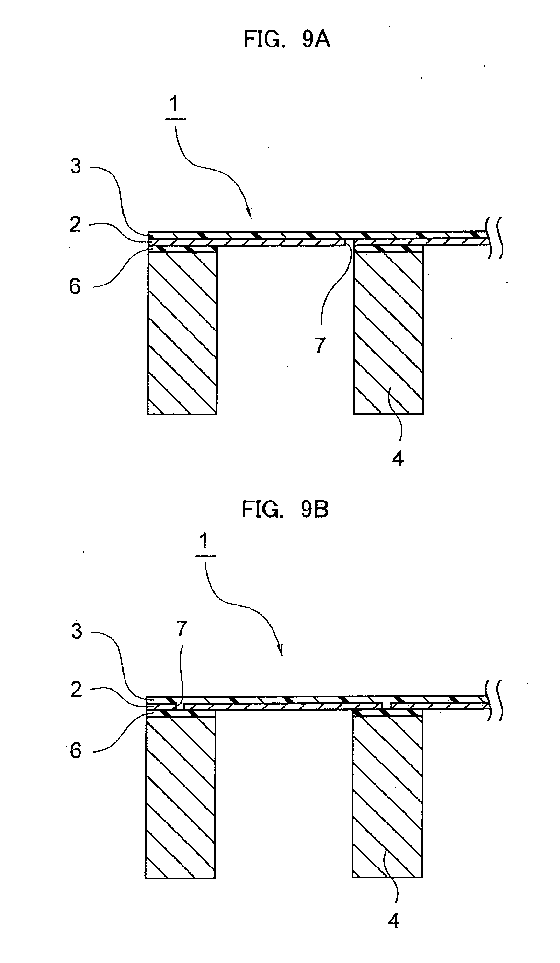

FIG. 9A is an example of forming the mask side alignment marks 7 on a portion not formed with a pattern (opening portions in the case of a stencil mask) near the beams 4. As the mask side alignment marks 7, other than using opening portions formed by performing etching for an amount of a thickness of the membrane 2 as shown in FIG. 9A, recessed portions formed by performing etching on the surface portion of the membrane 2 may be also used.

Also, as shown in FIG. 9B, mask side alignment marks 7 can be formed by removing a part of the membrane 2 on the beams 4 by etching. The mask side alignment marks 7 may be any as far as they have a different transmittance to the exposure beam for alignment from that on the peripheral portion, and the exposure beam for alignment to irradiate to the alignment marks on the alignment substrate is not interfered.

On the other hand, in FIG. 8, positions of the alignment marks 12 on the alignment substrate 11 are detected by the exposure beams for alignment transmitting through the mask blanks 1. The exposure beam for alignment 17A reflected on the alignment marks 12 is detected by the light detector 18A.

When the mask side alignment marks are provided, alignment of the mask blanks 1 and the alignment substrate 11 is performed by using the measured positions of the mask side alignment marks and positions of the alignment marks 12. After that, mask exposure is performed by referring to position coordinates of the alignment marks 12 input to the mask exposure apparatus in advance. After the mask exposure, by developing a resist and performing etching on the membrane 2 by using the resist as a mask, a lithography mask is obtained.

When the margin for matching the membrane 2 and the mask pattern is large, even if the mask side alignment marks are not specially provided, alignment of the mask blanks 1 and the alignment substrate 11 can be performed based on positions of the beams 4 detected by the exposure beam for alignment transmitting through the membrane 2 and the positions of the alignment marks 12.

In the case where a resist on the mask blanks is exposed by the exposure beam for alignment, the resist 3 on the alignment marks 12 in FIG. 2C is removed by development after mask exposure. As a result, in a step of performing etching on the membrane 2 by using the resist 3 as a mask to form opening portions (opening portions corresponding to the opening portions 108 in FIG. 1B), opening portions are formed also on portions irradiated with the exposure beam for alignment.

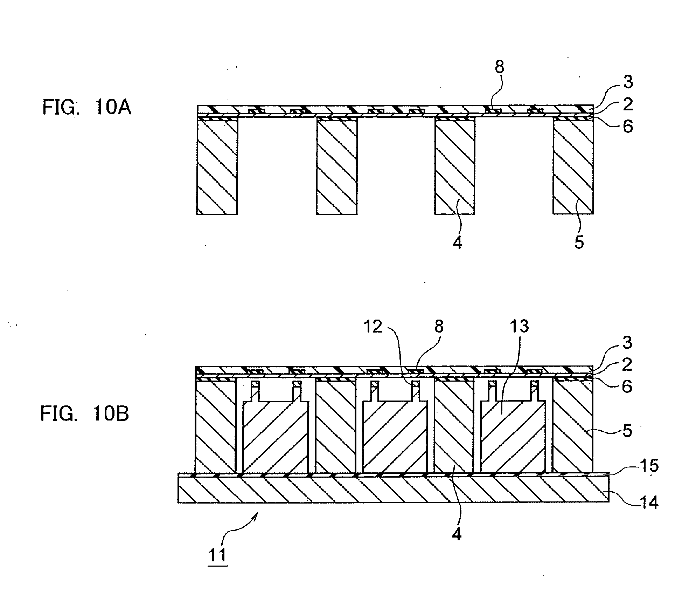

When the opening portions becomes problematic when using the mask for exposing the wafer (in the lithography step in producing a semiconductor device), for example, a mask blanks having a protective film as below is used as the countermeasure. FIG. 10A is a sectional view of a mask blanks having the protective film.

The mask blanks in FIG. 10A has a protective film 8 at positions on the alignment marks 12 and not superimposing with a pattern on the membrane 2 when being combined with the alignment substrate 11 as shown in FIG. 10B. Configuration other than that is the same as that in the mask blanks 1 in FIG. 2A.

In the present embodiment, single crystal silicon is used as a material of the membrane 2, so that, for example, a silicon oxide film is formed as a protective film 8, the membrane 2 is protected by the protective film 8 even if the resist 3 is removed. To form the protective film 8, before applying the resist 3 to the membrane 2, a silicon oxide film is formed allover the membrane 2, for example, by the chemical vapor deposition (CVD) and removed by etching so as to be left only on the alignment marks.

As a material of the protective film 8, any material other than oxide silicon may be used as far as it is not etched in a step of performing etching on the silicon membrane and it transmits the exposure beam for alignment when made to be a thin film having a thickness of the protective film 8. For example, instead of forming the protective film 8 in the above method, the protective film 8 can be formed by using a focused ion beam (FIB).

To form the protective film 8 by the FIB, a Ga ion beam is irradiated at positions on the alignment marks 12 while spraying an organic gas on a surface of the membrane 2. Since the gas is decomposed by energy of the ion beam and a carbon film is deposited, so that the protective film 8 is formed partially. The carbon film has sufficient resistance to washing performed after removing the resist 3. Accordingly, when the carbon film is formed to be a thickness of transmitting an exposure beam for alignment, it can be used as the protective film 8.

When the protective film 8 is formed as shown in FIG. 10A and FIG. 10B, conventionally known mask side alignment marks 7 as shown in FIG. 9 can be formed in accordance with need. When the margin for matching is large, it is not necessary to provide the mask side alignment marks as shown in FIG. 9. When the mask side alignment marks are not provided, alignment of the mask blanks and the alignment substrate 11 is performed based on positions of the beams 4.

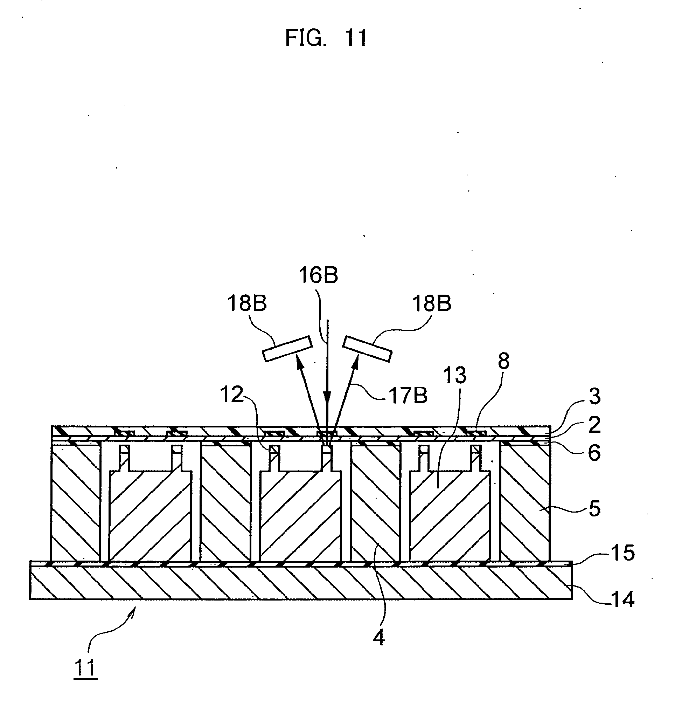

FIG. 11 shows a sectional view at the time of performing alignment of the mask blanks having the protective film 8 and the alignment substrate 11. When the protective film 8 is formed, a high acceleration electron beam used for mask exposure can be used for alignment. As shown in FIG. 11, the high acceleration electron beam 16B for alignment transmits through the membrane 2 and the resist 3 thereon and is irradiated to the alignment marks 12. An electron beam 17B reflected on the alignment marks 12 is detected by an electron beam detector 18B and positions of the alignment marks 12 are measured.

An alignment method shown in FIG. 11 is particularly preferable to alignment at the time of mask exposure for producing a stencil mask for LEEPL (low energy electron proximity projection lithography), which is one of electron beam transfer type lithography.

In the LEEPL, an electron beam having an accelerating voltage of, for example, 2 kV is used, and a mask pattern is projected at the same magnification on the wafer. Accordingly, it is necessary to form opening portions in a finer pattern on the membrane than on the mask to be used for reduced projection type lithography. When the membrane is thick, the aspect ratio of the opening portions becomes high and fine processing becomes difficult, so that an extremely thin membrane is used for a mask for LEEPL.

Also, a high acceleration electron beam having an accelerating voltage of, for example, 50 to 100 kV transmits through a membrane having a thickness of several hundreds nanometers or so, but a low acceleration electron beam used in the LEEPL is blocked by a membrane having a thickness of several hundreds nanometers or so and selectively passes only through the opening portions, so that a mask pattern is transferred.

On the other hand, since a high acceleration electron beam is used for mask exposure for producing a stencil mask for LEEPL, an electron beam for mask exposure can be also used for alignment by transmitting through the membrane and reflecting by the alignment marks on the alignment substrate.

As shown in FIG. 8 and FIG. 11, the alignment substrate, wherein positions of the alignment marks 12 are measured outside the mask exposure apparatus in advance, and the mask blanks are set in the mask exposure apparatus, and alignment explained above is performed. After that, a pattern is transferred to the resist by mask exposure.

When relative positions of the mask blanks and the alignment substrate shifts during the mask exposure, positional accuracy of the mask exposure declines, so that the aligned mask blanks and alignment substrate are fixed by using, for example, a pressing clamp and an electrostatic chuck.

Furthermore, before transferring the mask blanks and the alignment substrate to the mask exposure apparatus, it is preferable that a stage of the mask blanks and the alignment substrate at the time of measuring positions of alignment marks with high accuracy and a stage of the mask blanks and the alignment substrate in the mask exposure apparatus have the same mechanism. For example, when the mask blanks and the alignment substrate are fixed by the pressing clamp, a holding mechanism of the pressing clamp is preferably the same in the coordinates measuring device and the mask exposure apparatus.

In the alignment method of the present embodiment, alignment is performed by using the alignment marks arranged immediately under the membrane, so that a generally used variety of alignment detection systems can be applied in the same way as in the case where the alignment marks are formed on the membrane. Also, as far as it is not blocked by the membrane and the resist as the upper layer, any light or charged particle beam may be used for alignment, but the exposure beam for alignment is not limited to this and may be a charged particle beam, an extremely-short ultraviolet ray, an X-ray, an ultraviolet ray, radiation and/or visible light.

To perform alignment with high accuracy by a conventional alignment method, it was necessary that alignment marks for mask exposure were provided to the respective mask blanks, but according to the alignment method of the present embodiment, alignment marks are provided to the alignment substrate placed under the mask blanks by being superimposed. Therefore, it is not always necessary to form the alignment marks on the respective mask blanks. Due to this, the number of production steps and the production cost of a mask can be reduced.

Also, when performing alignment by providing alignment marks on the respective mask blanks, there are some cases where positions of the alignment marks are slightly different between the mask blanks due to an effect of an alignment mark formation process. Accordingly, it causes deviation of alignment between wirings of multilayer wiring of a semiconductor device or with a pattern (complementary divided pattern) formed on a complementary mask.

On the other hand, according to the alignment method of the present embodiment, since a common alignment substrate is used for alignment of mask blanks on which different mask patterns are drawn, positions of the alignment marks do not vary and alignment accuracy between masks can be improved.

Embodiments of the alignment method, alignment substrate, production method of an alignment substrate, exposure method, exposure apparatus and production method of a mask are not limited to the above explanation. For example, a laser beam and electron beam are used for alignment in the above embodiments, but an X-ray or a white light having a broad wavelength band, etc., such as a charged particle beam, extremely-short ultraviolet ray, X-ray, ultraviolet ray, radiation and/or visible light, can be used for alignment.

Other than the above, a variety of modifications can be made within the scope of the present invention.

According to the alignment method of the present invention, alignment with high accuracy can be performed without providing alignment marks on a mask, and it is possible to prevent a decline of throughput of exposure and a decline of latent image contrast due to alignment.

According to the alignment substrate of the present invention, it is possible to improve superimposing accuracy or combining accuracy of patterns between masks formed with different mask patterns. According to the production method of the alignment substrate of the present invention, an alignment substrate capable of detecting alignment marks at high contrast can be produced.

According to the exposure method and exposure apparatus of the present invention, it is possible to perform alignment with high accuracy when drawing a mask pattern even if alignment marks are not provided on the mask, and it is possible to prevent a decline of throughput of exposure and a decline of latent image contrast due to alignment.

According to the production method of a mask of the present invention, a lithography mask having high positional accuracy of a mask pattern can be produced.

### Industrial Applicability

The present invention can be applied to an alignment method for performing alignment in an exposure step, such as electron beam exposure, used in producing a semiconductor device, etc., an alignment substrate and the production method, an exposure method used for producing a semiconductor device, etc., an exposure device, and a production method of a mask.

### Explanation of References

- 1: mask blanks
- 2: membrane
- 3: resist
- 4: beam
- 5: supporting frame portion
- 6: etching stopper layer
- 7: mask side alignment mark
- 8: protective film
- 1: alignment substrate
- 12: alignment mark
- 13: alignment mark supporting portion
- 13a: step portion
- 14: first silicon wafer (substrate)
- 15: etching stopper layer
- 16A: alignment light
- 16B: electron beam for alignment
- 17A: reflection light of alignment light
- 17B: reflection beam of electron beam for alignment
- 18A: light detector
- 18B: electron beam detector
- 21: second silicon wafer
- 22: alignment mask formation layer
- 23, 24: resist
- 101: membrane mask
- 102: membrane
- 103: absorbing material
- 104: beam
- 105: supporting frame portion
- 106: stencil mask
- 107: membrane
- 108: opening portion
- 109: etching stopper layer

## Claims

1. An alignment method comprising:
a step of transmitting an exposure beam from a first surface side of a thin film to a second surface side and reflecting said exposure beam on a plurality of alignment marks arranged on said second surface side of said thin film and outside said thin film;
a step of detecting said exposure beam reflected on said alignment marks at said first surface side and detecting positions of said alignment marks; and
a step of obtaining position coordinates on said thin film using said detected position of said alignment marks.

2. An alignment method as set for claim 1, wherein said first surface of said thin film is a surface applied with a resist, and
said step of obtaining said position coordinates on said thin film includes a step of determining a position for drawing a mask pattern on said thin film.

3. An alignment method as set for claim 1, wherein said exposure beam is a charged particle beam, an extremely-short ultraviolet ray, an X-ray, an ultraviolet ray, a radiation and/or a visible light.

4. An alignment substrate arranged so that a surface thereof faces a second surface of a thin film at said second surface side of said thin film, into a first surface thereof an exposure beam entering, and
comprising a plurality of alignment marks formed on said surface and reflecting said exposure beam transmitting and entering through said thin film at higher reflectance than said surface at periphery thereof.

5. An alignment substrate as set forth in claim 4, wherein said surface at periphery of said alignment marks is formed farther from said second surface of said thin film than a surface of said alignment marks.

6. An alignment substrate as set forth in claim 4, wherein said alignment marks and said surface at periphery of said alignment marks are made from different materials.

7. An alignment substrate as set forth in claim 4, wherein said exposure beam is a charged particle beam, an extremely-short ultraviolet ray, an X-ray, an ultraviolet ray, a radiation and/or a visible light.

8. A production method of a alignment substrate comprising:
a step of forming an etching stopper layer on a first substrate;
a step of forming second substrate on said etching stopper layer;
a step of a plurality of alignment marks on a part of said second substrate;
a step of performing an etching to a surface layer portion of said second substrate using said alignment marks as a mask, and forming a step between a surface of said second substrate directly below said alignment marks and a surface of said second substrate at periphery of said alignment marks;
a step of forming a resist on said alignment marks and on a part of said second substrate at periphery of said alignment marks;
a step of performing an etching to said second substrate using said resist as a mask until said etching stopper layer is exposed; and
a step of removing said resist.

9. An exposure method comprising:
a step of measuring a position coordinates of a alignment marks in a alignment substrate having a plurality of said alignment marks thereon;
a step of arranging said alignment substrate so that a surface thereof faces a second surface of a thin film at said second surface side of said thin film, on a first surface thereof a resist being made,
a step of transmitting an exposure beam from said first surface side of said thin film to said second surface side and reflecting said exposure beam on said alignment marks;
a step of detecting said exposure beam reflected on said alignment marks at said first surface side and detecting positions of said alignment marks;
a step of determining positions for drawing a mask pattern on said resist using said detected positions of said alignment marks; and
a step of drawing said mask pattern on said resist by an exposure of a charged particle beam, an extremely-short ultraviolet ray, an X-ray, an ultraviolet ray, and/or a radiation.

10. An exposure method as set forth in claim 9, wherein said resist is not photosensitive to said exposure beam reflected on said alignment marks.

11. An exposure method as set forth in claim 9, wherein said resist is photosensitive to said exposure beam reflected on said alignment marks, and
before applying said resist on said first surface of said thin film and at a time arranging so that said thin film faces said alignment substrate, a step of forming a protective film of said thin film on a surface of said thin film arranged above said alignment marks is further included.

12. An exposure method as set forth in claim 11, wherein said step of forming said protective film includes a step of depositing a protective film material on said thin film and a step of removing said protective film material deposited on an unnecessary portion by etching.

13. An exposure method as set forth in claim 11, wherein said step of forming said protective film includes a step of irradiating a focused ion beam at positions where said protective film is to be formed under an existence of an organic gas and forming carbon film partially.

14. An exposure method as set forth in claim 9, wherein said exposure beam is a charged particle beam, an extremely-short ultraviolet ray, an X-ray, an ultraviolet ray, a radiation and/or a visible light.

15. An exposure apparatus comprising:
a thin film holding means for holding a thin film applied with a resist on a first surface thereof;
an alignment substrate holding means for holding an alignment substrate having a plurality of alignment marks on a surface thereof at a second surface side of said thin film so that said second surface of said thin film faces said surface;
an alignment detecting system irradiating an exposure beam at said first surface, reflecting said exposure beam on said alignment marks via said resist and said thin film, detecting said exposure beam reflected on said alignment marks at said first surface side, and measuring position coordinates of said alignment marks; and
a charged particle beam source, an extremely-short ultraviolet ray source, an X-ray source, an ultraviolet ray source, and/or a radiation source for drawing a mask pattern on said resist.

16. An exposure apparatus as set forth in claim 15, wherein said charged particle beam source, said extremely-short ultraviolet ray source, said X-ray source, said ultraviolet ray source, and/or said radiation for drawing said mask pattern are also used for irradiation of said exposure beam of said alignment detecting system which is a charged particle beam, an extremely-short ultraviolet ray, an X-ray, an ultraviolet ray, and/or a radiation.

17. An exposure apparatus as set forth in claim 15, wherein said exposure beam is a charged particle beam, an extremely-short ultraviolet ray, an X-ray, an ultraviolet ray, a radiation and/or a visible light.

18. A production method of a mask comprising:
a step of applying a resist on a first surface of a thin film;
a step of arranging an alignment substrate having a plurality of alignment marks on a surface thereof at a second surface side of said thin film so that said second surface of said thin film faces said surface;
a step of transmitting an exposure beam from said first surface side of said thin film to said second surface side and reflecting said exposure beam on said alignment marks;
a step of detecting said exposure beam reflected on said alignment marks at said first surface side and detecting positions of said alignment marks;
a step of determining positions for drawing a mask pattern on said resist using said detected positions of said alignment marks;
a step of drawing said mask pattern on said resist by an exposure of a charged particle beam, an extremely-short ultraviolet ray, an X-ray, an ultraviolet ray, and/or a radiation;
a step of developing said resist;
a step of performing an etching to said thin film using said resist as a mask and forming openings along said mask pattern; and
a step of removing said resist.

19. A production method of a mask as set forth in claim 18, wherein said resist is photosensitive to said exposure beam reflected on said alignment marks,
before applying said resist on said first surface of said thin film and at a time arranging so that said thin film faces said alignment substrate, a step of forming a protective film of said thin film on a surface of said thin film arranged above said alignment marks is further included, and
in said step of performing said etching to said thin film, said thin film is protected from said etching by said protective film.

20. A production method of a mask as set forth in claim 18, wherein said exposure beam is a charged particle beam, an extremely-short ultraviolet ray, an X-ray, an ultraviolet ray, a radiation and/or a visible light.
